Europäisches Patentamt

(19) European Patent Office

Office européen des brevets

(11) Numéro de publication: **0 033 685**
**B1**

(12) **FASCICULE DE BREVET EUROPEEN**

(45) Date de publication du fascicule du brevet:
01.08.84

(21) Numéro de dépôt: **81400114.5**

(22) Date de dépôt: **27.01.81**

(51) Int. Cl.³: **C 30 B 31/22, H 01 L 21/268**

(54) Procédé de dopage rapide de semiconducteurs.

(30) Priorité: **01.02.80 FR 8002239**

(43) Date de publication de la demande:
**12.08.81 Bulletin 81/32**

(45) Mention de la délivrance du brevet:
**01.08.84 Bulletin 84/31**

(84) Etats contractants désignés:
**CH DE GB LI**

(56) Documents cités:
**FR - A - 1 373 822**

**IBM TECHNICAL DISCLOSURE BULLETIN, vol. 16, no. 8, janvier 1974 New York, US G.L. HUTCHINS: "Localized semiconductor diffusions utilizing local laser melting in doping atmopsheres", pages 2585-2586**

(73) Titulaire: **COMMISSARIAT A L'ENERGIE ATOMIQUE Etablissement de Caractère Scientifique Technique et Industriel, B.P. 510, F-75752 Paris Cedex 15 (FR)**

(72) Inventeur: **Bruel, Michel, Lotissement Presvert, no. 19, F-38113 Veurey-Voroize (FR)**

(74) Mandataire: **Mongrédien, André et al, c/o BREVATOME 25, rue de Ponthieu, F-75008 Paris (FR)**

ACTORUM AG

## Description

La présente invention concerne un procédé de dopage rapide de semiconducteurs.

On sait que le dopage d'un semiconducteur consiste à faire pénétrer des particules étrangères, ou impuretés dans un substrat, constitué du semiconducteur à doper, et à rendre ces impuretés électriquement actives. L'adjonction d'impuretés dans un semiconducteur permet de modifier les propriétés physiques de celui-ci. Ce semiconducteur peut se présenter sous la forme d'un monocristal et/ou peut déjà être dopé.

Les principales applications des semiconducteurs dopés sont la fabrication de différents composants du type diodes, transistors, thyristors, etc... et la fabrication de cellules solaires.

On connaît plusieurs procédés de dopage des semiconducteurs comme, par exemple, l'implantation ionique, la diffusion, la croissance épitaxiale, la technique d'alliage, etc... Les différents procédés de dopage utilisés dépendent des impuretés avec lesquelles on dope le semiconducteur, du matériau constituant ce dernier, et du type de dopage que l'on désire obtenir.

Dans ces différents procédés de dopage, l'introduction des impuretés dans le substrat est un processus lent qui dure en général plusieurs heures, ou au moins plusieurs minutes. Il en est ainsi, notamment dans le cas du procédé de dopage par implantation ionique. Ce procédé de dopage se déroule en deux étapes distinctes.

La première étape consiste à implanter le substrat au moyen d'un faisceau d'ions, ou de particules, faisceau dont la section est de l'ordre du cm² ou du mm². Le point d'impact sur le substrat du faisceau de particules, ou d'ions, se déplace de façon à couvrir toute la surface du substrat de façon homogène. Cette première étape, ou prédépôt, est généralement lente.

Des études ont montré que jamais deux ions, ou particules, n'arrivent en même temps sur le substrat. De plus, les écarts entre les instants d'arrivée entre deux particules font que l'énergie se dissipe progressivement dans toute la masse du substrat. L'échauffement produit, lors de la pénétration des particules dans le substrat, reste très faible et ne saurait produire l'effet de recuit nécessaire pour rendre les impuretés électriquement actives et pour permettre le réarrangement du réseau cristallin qui a été perturbé, lors du bombardement du substrat par les particules ou ions. Cette étape de recuit constitue la deuxième étape de ce procédé de dopage. Ce recuit consiste, par exemple, à porter à différentes températures l'échantillon du substrat implanté (entre 0° et 1400 °C) pendant un temps variable, pouvant aller jusqu'à plusieurs heures, dans des fours appropriés.

Pour cette deuxième étape, on utilise aussi ce qu'on appelle un recuit transitoire qui consiste à apporter à la surface, ou au niveau des premières couches implantées, pendant un temps très bref, une densité d'énergie telle que de très hautes températures soient atteintes localement pendant ce temps. Des études ont montré que les meilleurs résultats sont obtenus en général lorsque l'apport d'énergie est suffisant pour liquéfier les premières couches du substrat.

L'apport d'énergie peut se faire de différentes façons et en particulier à l'aide d'un tir d'énergie lumineuse au moyen, par exemple, d'un laser ou d'une lampe flash, ou de faisceaux pulsés d'électrons.

Cette méthode de dopage, par implantation ionique présente l'inconvénient de se dérouler en deux étapes, et de plus, comme toutes les autres méthodes citées ci-dessus, les différentes étapes du procédé sont longues.

On connaît aussi un procédé de dopage de semiconducteurs utilisant un faisceau laser à balayage ou un faisceau d'électrons permettant de fondre localement le substrat desdits semiconducteurs. Ce procédé est décrit dans la publication IBM Technical Disclosure Bulletin, vol. 16, n° 8, de janvier 1974, New York, dans un article intitulé «Localized semiconductor diffusions utilizing local laser melting in doping atmospheres» pages 2585–2586 de G.L. Hutchins.

La présente invention a donc pour objet un procédé de dopage rapide de semiconducteurs qui permet de remédier à ces inconvénients et notamment d'éviter la phase de recuit en diminuant le temps d'implantation des particules ou ions dans le substrat.

Selon l'invention, ce procédé de dopage se caractérise en ce que les particules étrangères, ou impuretés, constituant le matériau dopant, sont envoyées sur le substrat sous la forme d'un faisceau d'ions intense et pulsé ou sous la forme d'un faisceau d'amas polyatomiques et arrivent sur le substrat de façon rapprochée dans le temps et dans l'espace de manière que l'énergie apportée par chaque particule, lors de son implantation dans le substrat, coopère avec l'énergie des autres particules de façon à produire une liquéfaction locale du substrat, permettant le positionnement des particules dans les sites interstitiels du réseau cristallin du substrat et le réarrangement dudit réseau cristallin, perturbé lors de la pénétration des particules dans le substrat.

Selon un premier mode de réalisation de l'invention, les particules sont envoyées sur le substrat sous la forme d'un faisceau d'ions, intense et pulsé, c'est-à-dire, comportant un grand nombre de particules possédant chacune une forte énergie cinétique et envoyé sous la forme d'impulsions.

Cette pulsation du faisceau peut être obtenue, soit sur l'ensemble par modulation dans le temps de la source d'ions, soit en chaque point du substrat par balayage dans l'espace d'un faisceau continu intense de petite section.

Selon une première variante, le faisceau d'ions est obtenu à partir d'une interaction entre un faisceau laser et une cible constituée du matériau dopant.

Selon une deuxième variante, le faisceau d'ions est obtenu à l'aide d'un accélérateur à plasma permettant la focalisation du faisceau d'ions et constitué par une électrode cylindrique, une électrode filiforme coaxiale à cette électrode cylindrique, des moyens pour appliquer entre ces électrodes une tension élevée, des moyens pour amorcer une décharge électrique à l'une des extrémités de l'espace interélectrode et des moyens pour introduire à cette extrémité une bouffée de gaz, de telle sorte que la décharge électrique se propage vers l'autre extrémité de l'espace interélectrode et crée un plasma dense et chaud à cette autre extrémité. Cet accélérateur est généralement connu sous le nom de «Plasmafocus».

Selon une troisième variante, le faisceau d'ions est obtenu à l'aide d'une triode à réflexion constituée de deux cathodes placées de part et d'autre d'une anode de faible épaisseur permettant aux électrons, émis par l'une des cathodes de traverser ladite anode, les électrons étant ensuite réfléchis par l'autre cathode sur l'anode constituée en matériau dopant. Cette triode à réflexion est généralement connue sous le nom de «reflex triode source».

Selon une quatrième variante, le faisceau d'ions est obtenu à l'aide d'une diode constituée d'une cathode et d'une anode placées dans un champ magnétique perpendiculaire au champ électrique créé entre la cathode et l'anode constituée en matériau dopant. Ce champ magnétique permet de renvoyer les électrons émis par la cathode sur ladite cathode et de favoriser l'extraction des ions de l'anode, ces ions n'étant que légèrement déviés par ledit champ magnétique.

Selon une cinquième variante, le plasma est obtenu à l'aide d'une diode constituée d'une cathode qui émet des électrons, ces électrons sont captés par une anode de forme arrondie et constituée du matériau dopant, l'interaction des électrons avec l'anode permettant la production du faisceau d'ions qui est focalisé du fait même de la forme de ladite anode.

Selon une sixième variante, le faisceau d'ions est obtenu par une source de décharge à étincelle sous vide. Cette source est généralement connue sous le nom de «vacuum spark ionisation source». Une étincelle est développée entre deux électrodes dont l'une est constituée du matériau dopant. L'étincelle est alimentée pendant sa durée de vie par un courant très intense. Ceci permet la génération de faisceaux d'ions très intenses.

Selon un deuxième mode de réalisation de l'invention, les particules sont envoyées sur le substrat sous la forme d'un faisceau d'amas polyatomiques. Les amas polyatomiques sont généralement connus sous le nom de «Clusters».

Selon une première variante, le faisceau d'amas polyatomiques est obtenu à partir d'un solide, constitué par le matériau dopant, par une méthode de désorption rapide sous vide.

Selon une deuxième variante, le faisceau d'amas polyatomiques est obtenu à partir d'impact d'atomes lourds sur une cible constituée en matériau dopant.

Selon une troisième variante, le faisceau d'amas polyatomiques est obtenu par une détente supersonique de vapeur à travers une buse dans le vide.

Selon l'invention, dans certains cas, les particules sont accélérées à l'aide d'un champ électrique, permettant de fournir tout ou partie de l'énergie nécessaire à la liquéfaction locale du substrat.

Selon l'invention, dans d'autres cas, les particules peuvent être combinées à un autre faisceau de particules de façon à apporter une énergie supplémentaire, nécessaire à la liquéfaction locale du substrat. Ce faisceau de particules supplémentaire peut être, par exemple, un faisceau d'électrons, de photons, d'ions, etc.

Ce procédé de dopage présente l'avantage de pouvoir être utilisé pour doper n'importe quel type de semiconducteurs, en utilisant n'importe quel type de matériau dopant. De plus, il permet de contrôler facilement la quantité d'impuretés introduites dans le substrat.

Cette méthode de dopage est rapide et n'a lieu qu'en une seule étape. La densité d'énergie nécessaire pour la mise en œuvre du procédé de dopage rapide de façon à obtenir la liquéfaction locale du substrat, dépend du matériau dans lequel on veut faire l'implantation des particules, de la durée pendant laquelle on apporte cette énergie sur le substrat et de la profondeur de la pénétration des particules, si la durée d'apport d'énergie est très courte.

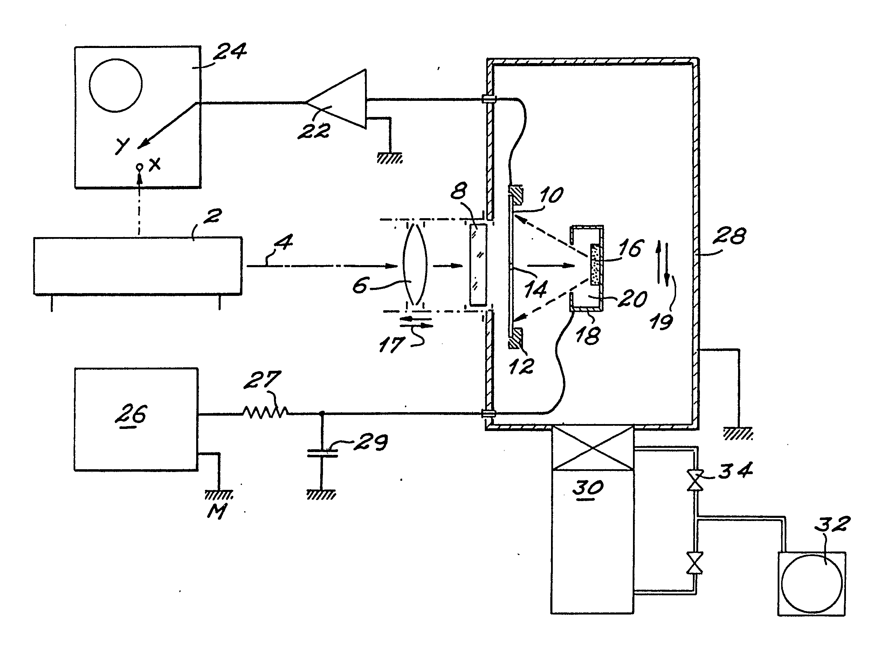

D'autres caractéristiques et avantages de l'invention ressortiront mieux à l'aide de la description qui va suivre, donnée à titre purement illustratif et non limitatif, en référence à l'unique figure, qui représente un schéma général d'un dispositif, mettant en œuvre le procédé de dopage selon l'invention.

Un laser 2 envoie un faisceau lumineux 4. Ce faisceau 4 est focalisé à l'aide de lentilles 6, convergentes, traverse un hublot 8 puis une plaquette 10, constituée du matériau à doper. Cette plaquette est maintenue fixe à l'aide de deux supports tels que 12 et est munie d'un trou 14 permettant le passage du faisceau laser 4. Ce faisceau arrive sur une cible 16 constituée par le matériau dopant et placée sous vide. Cette cible 16 est une surface polie sur laquelle peut se déplacer le point d'impact du faisceau laser 4. La référence 17 indique le déplacement possible de la lentille 6. Ce déplacement permet de modifier la dimension de la tache de focalisation sur la cible 16, ce qui, pour une surface d'impact minimum, permet d'obtenir un flux de puissance maximum. Pour ajuster la focalisation du faisceau lumineux 4 du laser 2, on peut utiliser un second faisceau laser à gaz d'Hélium et de Néon (non représenté).

De façon à modifier le point d'impact du faisceau 4 sur la cible 16, on peut déplacer, de façon continue, la cible 16 par tout moyen connu. Le balayage de la cible 16 par le déplacement de celle-ci est représenté par la référence 19. Le bombardement de cette cible 16 à l'aide du faisceau 4 donne lieu à la création d'un cratère avec vaporisation et formation d'un faisceau d'ions.

Bien entendu, le taux d'ionisation de la matière éjectée de la cible est d'autant plus élevé que la densité de puissance apportée par le laser est élevée. Pour avoir une interaction laser matière efficace, il faut apporter des densités de puissances comprises entre $10^{13}$ et $10^{17}$ W/m². Il est ainsi possible de produire en un seul «tir» laser $10^{13}$ à $10^{18}$ ions.

L'extraction du faisceau d'ions peut être réalisée à l'aide d'un champ électrique, appliqué entre la plaquette 10 et la face externe 18 d'une cuvette d'expansion 20, lorsque celle-ci est utilisée, ou directement entre la plaquette 10 du matériau à doper et la cible 16 en matériau dopant. Le faisceau d'ions, en venant frapper la plaquette 10, crée un courant que l'on amplifie à l'aide d'un amplificateur 22. Le signal obtenu à la sortie de cet amplificateur 22 peut être visualisé sur un oscilloscope à mémoire 24, la base de temps de cet oscilloscope étant déclenchée par un signal de synchronisation fourni par le laser 2. Ce dispositif permet d'estimer le nombre d'ions recueilli par la plaquette 10 à chaque essai, ou «tir» laser.

Le champ électrique, permettant l'extraction des ions peut être obtenu à l'aide d'une source d'alimentation 26, en haute tension continue (de l'ordre de 30 kV), reliée à la masse. Cette alimentation 26 peut être reliée à une résistance de protection 27 et à une capacité 29 servant de réservoir d'énergie. La plaquette 10 et la cible 16 placée dans la cuvette d'expansion 20, sont situées dans une chambre à vide 28 reliée à la masse. Le vide, effectué dans cette chambre 28, de l'ordre de $133,322 \times 10^{-6}$ Pa, est obtenu à l'aide, par exemple, d'une pompe à diffusion 30 et d'une pompe à palette 32 reliées entre elles par des vannes telles que 34.

Afin que le dopage rapide décrit ci-dessus soit possible, il est nécessaire de réaliser l'apport d'énergie en un temps suffisamment court pour que cet apport d'énergie soit adiabatique et que le recuit transitoire ait lieu simultanément à l'implantation des particules, ou ions, dans le substrat. Dans le cas d'une implantation de particules dans un substrat en silicium, la densité totale d'énergie doit être supérieure à un seuil de 0,5 J/cm², cette densité d'énergie étant à apporter pendant un temps très court de l'ordre de quelques centaines de nanosecondes. Pour ces raisons, on peut utiliser, par exemple, un laser à rubis fournissant des impulsions lumineuses de 15 nanosecondes de durée et transportant une énergie de 0,5 Joule. De plus, l'utilisation d'un second faisceau laser à Hélium et Néon permet une bonne focalisation de ce faisceau. Un ajustement fin de la focalisation du laser et un réglage de celui-ci permettent une bonne optimisation du nombre de particules, ou impuretés, reçues par la plaquette, constituée du matériau à doper. Il est à noter qu'un seul «tir» laser est nécessaire pour doper cette plaquette.

De plus, dans le cas d'une interaction laser-matière, à très forte densité de puissance (au-delà de $10^{12}$ W/cm²), il est possible de réaliser le dopage rapide, sans accélération supplémentaire des particules. Dans ce cas, le faisceau d'ions obtenu est très énergétique (énergie $\geqslant 1$ keV) et les particules sont très directives.

Suivant les cas, on utilise les faisceaux d'ions pulsés ou les faisceaux d'amas polyatomiques. L'utilisation des faisceaux d'ions pulsés aboutit à un dopage au niveau macroscopique (quelques milliers d'Angströms à quelques centimètres), en revanche, l'utilisation d'un faisceau d'amas polyatomiques conduit à un dopage au niveau microscopique (quelques dizaines d'Angströms à quelques milliers d'Angströms).

Le dopage macroscopique par faisceau d'ions pulsé présente deux variantes. Dans l'une, le faisceau est large, immobile par rapport au substrat, et modulé en intensité; il permet le dopage d'une grande surface de substrat comme par exemple une plaquette entière. Dans l'autre, le faisceau est étroit, de densité de courant élevée, typiquement de 10 A/cm², et le caractère transitoire de l'implantation et du recuit est dû au faible temps de passage en chaque point de la plaquette.

Le dopage macroscopique par faisceau d'ions est adapté à des productions de très grande série et où les tolérances de reproductibilité ne sont pas trop sévères. Le dopage microscopique par faisceau d'amas est beaucoup plus souple; il permet d'utiliser des faisceaux continus de faible densité et il est compatible avec un contrôle en temps réel du dopage.

Pour réaliser un dopage au niveau microscopique, il suffit que la densité volumique d'énergie apportée par une particule à implanter soit suffisante pour liquéfier une zone du substrat de quelques centaines d'Angströms, par exemple. Pour un amas polyatomique contenant, par exemple, N atomes, on a observé que la pénétration de l'amas dans le substrat est du même ordre de grandeur que celle qui correspond à l'atome isolé, de même énergie que chaque atome de l'amas, donc le volume intéressé par l'apport d'énergie est du même ordre de grandeur. En conséquence, la densité volumique d'énergie, apportée par l'amas au substrat est multipliée par N. Il suffit de choisir N supérieur à une certaine valeur pour obtenir la liquéfaction microscopique du substrat.

La formation de ces amas polyatomiques peut être obtenue soit par une méthode de désorption sous vide à partir d'un solide constitué en matériau dopant, soit par impact d'atomes lourds sur une cible constituée en matériau dopant, soit par détente supersonique de vapeur à travers une buse dans le vide. La description des différents moyens d'obtention de ces faisceaux d'amas polyatomiques ont été décrits dans l'I.E.E.E Transactions on Nuclear Sciences, volume NS 26, n° 1, paru en février 1979 dans un article intitulé «Production and impact effects of fast particles» pages 1232 à 1234.

Dans le cas d'utilisation d'un faisceau d'amas polyatomiques seul, le fait de heurter le substrat à l'aide de faisceaux entraîne la dispersion des atomes de l'amas lorsque celui-ci pénètre dans le substrat. En revanche, lorsque l'on associe ce faisceau à un faisceau secondaire (d'électrons, de photons...) la dispersion des atomes de l'amas est obtenue avant qu'ils ne pénètrent dans le substrat. Ceci permet de répartir l'énergie dans un plus grand volume du substrat et de façon plus homogène.

La formation d'un faisceau d'ions intense et pulsé peut être, bien entendu, obtenu autrement qu'au moyen de l'interaction laser-matière décrite ci-dessus. Celui-ci peut être obtenu, notamment, à l'aide d'un accélérateur à plasma, d'une triode à réflexion, d'une diode dont l'anode et la cathode peuvent présenter des formes différentes, d'une source de décharge à étincelle sous vide, de sources d'ions à très haute brillance spécifique. La description de ces différents moyens d'obtention d'un faisceau d'ions, ainsi que leur fonctionnement ont été décrits dans différentes publications telles que:
- dans l'I.E.E.E Transactions on Nuclear Science, volume NS 26, n° 1 paru en février 1979 dans un article intitulé «Production and impact effects of fast particles», pages 1228 à 1234;
- dans le Sov. Phys. Tech. Phys. paru le 23 septembre 1978 dans un article intitulé «Technical applications of plasma accelerators», pages 1058 à 1054;
- dans les Proceedings of Fourth Conference on the Scientific and Industrial Applications of Small Accelerators, North Texas State University, du 27 au 29 octobre 1976, dans un article intitulé «Production of intense pulsed ion beams for near term applications», pages 203 à 214.

On peut également, pour la mise en œuvre de l'invention, avoir recours à la technique connue sous le nom d'accélération collective des ions et décrite par exemple dans les articles suivants parus dans I.E.E.E Transactions on Nuclear Science, vol. NS 26, n° 3 paru en juin 1979 dans des articles intitulés «Current Status of collective accelerators», pages 4156 à 4158 et «Experimental studies of heavy ion collective acceleration at the University of Maryland», pages 4177 à 4180.

Ce procédé de dopage rapide, conformément à l'invention, a été réalisé à l'aide d'une plaquette de silicium, constituant le semiconducteur à doper, un faisceau d'ions de bore, pour un dopage de type p et un faisceau d'ions d'antimoine pour un dopage de type n.

Le nombre d'ions implanté dans une plaquette de silicium est de $5.10^{14}$ par cm² pour le dopant bore et de $2.10^{14}$ par cm² pour le dopant antimoine. Cette mesure a été effectuée par activation neutronique dans le cas de l'antimoine et au moyen d'un analyseur ionique dans le cas du bore.

**Revendications**

1. Procédé de dopage rapide de semiconducteurs, consistant à faire pénétrer des particules étrangères dans un substrat (14) et à les rendre électriquement actives, de façon à modifier les propriétés physiques dudit substrat, caractérisé en ce que les particules étrangères, constituant le matériau dopant, sont envoyées sur le substrat (14) sous la forme d'un faisceau d'ions intense et pulsé ou sous la forme d'un faisceau d'amas polyatomique et arrivent sur le substrat (14) de façon rapprochée dans le temps et dans l'espace, de manière que l'énergie apportée par chaque particule lors de son implantation dans le substrat (14) coopère avec l'énergie des autres particules de façon à produire une liquéfaction locale du substrat, permettant le positionnement des particules dans les sites interstitiels du réseau cristallin du substrat et le réarrangement dudit réseau cristallin, perturbé lors de la pénétration des particules dans le substrat.

2. Procédé de dopage selon la revendication 1, caractérisé en ce que le faisceau intense et pulsé est fixe par rapport au substrat (14) et modulé en intensité.

3. Procédé de dopage selon la revendication 1, caractérisé en ce que le faisceau intense et pulsé est obtenu en chaque point du substrat par balayage d'un faisceau continu intense.

4. Procédé de dopage selon l'une quelconque des revendications 1 à 3, caractérisé en ce que le faisceau d'ions est obtenu à partir d'une interaction entre un faisceau laser (2) et une cible (16) constituée du matériau dopant.

5. Procédé de dopage selon l'une quelconque des revendications 1 à 3, caractérisé en ce que le faisceau d'ions est obtenu à l'aide d'un accélérateur à plasma permettant la focalisation du faisceau d'ions et constitué par une électrode cylindrique, une électrode filiforme coaxiale à cette électrode cylindrique, des moyens pour appliquer entre ces électrodes une tension élevée, des moyens pour amorcer une décharge électrique à l'une des extrémités de l'espace interélectrode et des moyens pour introduire à cette extrémité une bouffée de gaz, de telle sorte que la décharge électrique se propage vers l'autre extrémité de l'espace interélectrode et crée un plasma dense et chaud à cette autre extrémité.

6. Procédé de dopage selon l'une quelconque des revendications 1 à 3, caractérisé en ce que le faisceau d'ions est obtenu à l'aide d'une triode à réflexion constituée de deux cathodes placées de part et d'autre d'une anode de faible épaisseur permettant aux électrons émis par l'une des cathodes de traverser ladite anode, les électrons étant ensuite réfléchis par l'autre cathode sur l'anode constituée du matériau dopant.

7. Procédé de dopage selon l'une quelconque des revendications 1 à 3, caractérisé en ce que le faisceau d'ions est obtenu à l'aide d'une diode constituée d'une cathode et d'une anode placée dans un champ magnétique perpendiculaire au champ électrique créé entre la cathode et l'anode constituée en matériau dopant.

8. Procédé de dopage selon l'une quelconque des revendications 1 à 3, caractérisé en ce que le faisceau d'ions est obtenu à l'aide d'une diode constituée d'une cathode qui émet des électrons, ces électrons sont captés par une anode de forme arrondie et constituée du matériau dopant, l'interaction des électrons avec l'anode permettant la production du faisceau d'ions qui est focalisé du fait même de ladite anode.

9. Procédé de dopage selon l'une quelconque des revendications 1 à 3, caractérisé en ce que le faisceau d'ions est obtenu par une source de décharge à étincelle, sous vide, constituée de deux électrodes entre lesquelles est produite une étincelle, l'une des électrodes étant constituée du matériau dopant.

10. Procédé de dopage selon la revendication 1, caractérisé en ce que le faisceau d'amas polyatomiques est obtenu à partir d'un solide constitué par le matériau dopant, par une méthode de désorption rapide sous vide.

11. Procédé de dopage selon la revendication 1, caractérisé en ce que le faisceau d'amas polyatomiques est obtenu à partir d'un impact d'atomes lourds sur une cible constituée en matériau dopant.

12. Procédé de dopage selon la revendication 1, caractérisé en ce que le faisceau d'amas polyatomiques est obtenu par une détente supersonique de vapeur à travers une buse dans le vide.

13. Procédé de dopage selon l'une quelconque des revendications 1 à 12, caractérisé en ce que les particules peuvent être combinées à un autre faisceau de particules de façon à apporter une énergie supplémentaire, nécessaire à la liquéfaction locale du substrat.

14. Procédé de dopage selon l'une quelconque des revendications 1 à 12, caractérisé en ce que les particules sont accélérées à l'aide d'un champ électrique, permettant de fournir tout ou partie de l'énergie nécessaire à la liquéfaction locale du substrat.

**Claims**

1. Process for the rapid doping of semiconductors comprising causing foreign particles to penetrate into a substrate (14) and making them electrically active, whereby to modify the physical properties of said substrate, characterized in that the foreign particles constituting the dopant material are conveyed to the substrate (14) in the form of an intense, pulsed ion beam or of a beam of polyatomic aggregates, and reaches the substrate (14) in a manner concentrated in time and in space, whereby the energy carried by each particle at the time of its implantation into the substrate (14) cooperates with the energy of the other particles to produce local liquefaction of the substrate, enabling positioning of the particles in the interstitial sites of the crystal lattice of the substrate, and the rearrangement of the said crystal lattice perturbed by the penetration of the particles into the substrate.

2. Doping process according to Claim 1, characterized in that the intense pulsed beam is fixed with respect to the substrate (14) and its intensity is modulated.

3. Doping process accroding to Claim 1, characterized in that the intense, pulsed beam is obtained at each point on the substrate by sweeping with a continuous intense beam.

4. Doping process according to any one of Claims 1 to 3, characterized in that the ion beam is obtained by interaction between a laser beam (2) and a target (16) comprising a dopant material.

5. Doping process according to any one of Claims 1 to 3, characterized in that the ion beam is obtained with a plasma accelerator permitting focussing of the ion beam, and constituted by a cylindrical electrode and a filamentary electrode coaxial with said cylindrical electrode, means for applying an elevated potential difference between said electrodes, means for initiating an electric discharge at one end of the interelectrode space and means to introduce a jet of gas at that end, whereby the electric discharge is propagated towards the other end of the interelectrode space, and creates a hot, dense plasma at said other end.

6. Doping process according to any one of Claims 1 to 3, characterized in that the ion beam is obtained with the aid of a reflection triode, comprising two cathodes located one on each side of an anode of small thickness, permitting electrons emitted by one of the cathodes to pass through said anode, the electrons being then reflected by the other cathode on to the anode comprising dopant material.

7. Doping process according to any one of Claims 1 to 3, characterized in that the ion beam is obtained with the aid of a diode comprising a cathode and an anode located within a magnetic field perpendicular to the electric filed between the cathode and the anode comprising dopant material.

8. Doping process according to any one of Claims 1 to 3, characterized in that the ion beam is obtained with the aid of a diode, comprising a cathode that emits electrons, said electrons being captured by an anode of rounded form and comprising dopant material, interaction of the electrons with the anode permitting production of an ion beam which is focussed by virtue of said anode.

9. Doping process according to any one of Claims 1 to 3, characterized in that the ion beam is obtained from vacuum spark discharge means, comprising two electrodes between which a spark is produced, one of the said electrodes comprising dopant material.

10. Doping process according to Claim 1, characterized in that the beam of polyatomic aggregates is obtained from a solid comprising the dopant material by a rapid desorption method under vacuum.

11. Doping process according to Claim 1, characterized in that the beam of polyatomic aggregates is obtained by impact of heavy atoms on a target comprising dopant material.

12. Doping process according to Claim 1, characterized in that the beam of polyatomic aggregates is obtained by supersonic vapour expansion through a nozzle under vacuum.

13. Doping process according to any one of Claims 1 to 12, characterized in that the particles are combined with another beam of particles whereby to supply supplementary energy necessary for local liquefaction of the substrate.

14. Doping process according to any one of Claims 1 to 12, characterized in that the particles are accelerated by an electrical field, whereby to supply all or part of the energy necessary for local liquefaction of the substrate.

**Patentansprüche**

1. Schnelles Verfahren zum Dotieren von Halbleitern, bei dem man fremde Teilchen in ein Substrat (14) eindringen lässt und diese elektrisch aktiv macht, derart, dass die physikalischen Eigenschaften des Substrats geändert werden, dadurch gekennzeichnet, dass die das Dotierungsmaterial bildenden fremden Teilchen auf das Substrat (14) in der Form eines intensiven und gepulsten Ionenstrahlenbündels oder in der Form eines Strahles von vielatomigen Anhäufungen gesandt werden und auf dem Substrat (14) zeitlich und räumlich nahe beieinander derart ankommen, dass die von jedem Teilchen bei seiner Implantation in das Substrat (14) mitgeführte Energie mit der Energie der anderen Teilchen derart zusammenwirkt, dass eine örtliche Verflüssigung des Substrats hervorgrufen wird, wodurch die Anordnung der Teilchen in den Zwischenräumen des Kristallgitters des Substrats und die Umordnung des beim Eintreten der Teilchen in das Substrat gestörten Kristallgitters ermöglicht wird.

2. Dotierungsverfahren nach Anspruch 1, dadurch gekennzeichnet, dass das intensive und gepulste Strahlenbündel relativ zu dem Substrat (14) stationär ist und seine Intensität moduliert wird.

3. Dotierungsverfahren nach Anspruch 1, dadurch gekennzeichnet, dass das intensive und gepulste Strahlenbündel an jeder Stelle des Substrats durch Überstreichen mit einem intensiven, kontinuierlichen Strahlenbündel erhalten wird.

4. Dotierungsverfahren nach irgendeinem der Ansprüche 1 bis 3, dadurch gekennzeichnet, dass das Ionenstrahlenbündel ausgehend von einer Wechselwirkung zwischen einem Laserstrahlenbündel (2) und einem Ziel (16) erhalten wird, welches das Dotiermaterial bildet.

5. Dotierungsverfahren nach irgendeinem der Ansprüche 1 bis 3, dadurch gekennzeichnet, dass das Ionenstrahlenbündel mittels eines Plasmabeschleunigers erhalten wird, der die Fokussierung des Ionenstrahlenbündels ermöglicht und der gebildet ist von einer zylinderförmigen Elektrode, einer zu dieser zylinderförmigen Elektrode koaxialen, drahtförmigen Elektrode, Mitteln um zwischen diesen Elektroden eine hohe Spannung anzulegen, Mitteln um eine elektrische Entladung an einem der Enden des Zwischenelektrodenraumes einzuleiten, und Mitteln, um an diesem Ende einen Gasausbruch derart einzuführen, dass sich die elektrische Entladung zu dem anderen Ende des Zwischenelektrodenraumes fortpflanzt und ein dichtes und heisses Plasma an diesem anderen Ende erzeugt.

6. Dotierungsverfahren nach irgendeinem der Ansprüche 1 bis 3, dadurch gekennzeichnet, dass das Ionenstrahlenbündel mittels einer Reflexions-triode erhalten wird, die aus zwei Kathoden gebildet ist, die auf beiden Seiten einer Anode geringer Dicke angeordnet sind, die den von einer der Kathoden emittierten Elektroden den Durchgang durch die Anode ermöglicht, wobei die Elektronen anschliessend von der anderen Kathode zu der das Dotierungsmaterial bildenden Anode reflektiert werden.

7. Dotierungsverfahren nach irgendeinem der Ansprüche 1 bis 3, dadurch gekennzeichnet, dass das Ionenstrahlenbündel mittels einer Diode erhalten wird, die von einer Kathode und einer Anode gebildet ist, welche in einem Magnetfeld angeordnet ist, das senkrecht zu dem zwischen der Kathode und der aus dem Dotierungsmaterial bestehenden Anode erzeugten elektrischen Feld ist.

8. Dotierungsverfahren nach irgendeinem der Ansprüche 1 bis 3, dadurch gekennzeichnet, dass das Ionenstrahlenbündel mittels einer Diode erhalten wird, die von einer Kathode gebildet ist, welche Elektronen aussendet, wobei die Elektronen von einer Anode aufgefangen werden, die eine abgerundete Form aufweist und aus dem Dotierungsmaterial besteht, und dass die Wechselwirkung der Elektronen mit der Anode die Erzeugung des Ionenstrahlenbündels ermöglichen, welches durch die Anode selbst fokussiert wird.

9. Dotierungsverfahren nach irgendeinem der Ansprüche 1 bis 3, dadurch gekennzeichnet, dass das Ionenstrahlenbündel durch eine Funkenentladungsquelle im Vakuum erhalten wird, die aus zwei Elektroden besteht, zwischen denen ein Funken erzeugt wird, wobei eine der Elektroden aus dem Dotierungsmaterial gebildet ist.

10. Dotierungsverfahren nach Anspruch 1, dadurch gekennzeichnet, dass das Strahlenbündel aus vielatomigen Anhäufungen ausgehend von einem festen Körper, der aus dem Dotierungsmaterial gebildet ist, mittels eines schnellen Desorptionsverfahrens im Vakuum erhalten wird.

11. Dotierungsverfahren nach Anspruch 1, dadurch gekennzeichnet, dass das Strahlenbündel vielatomiger Anhäufungen ausgehend von einer Bombardierung schwerer Atome auf ein Ziel erhalten wird, welches aus dem Dotierungsmaterial gebildet ist.

12. Dotierungsverfahren nach Anspruch 1, dadurch gekennzeichnet, dass das Strahlenbündel vielatomiger Anhäufungen durch eine Ultraschall-Dampfentspannung quer zu einer Düse im Vakuum erhalten wird.

13. Dotierungsverfahren nach irgendeinem der Ansprüche 1 bis 12, dadurch gekennzeichnet, dass die Teilchen mit einem anderen Teilchenstrahlenbündel kombiniert werden könne, derart, dass eine zusätzliche Energie zugeführt wird, die zur örtlichen Verflüssigung des Substrats erforderlich ist.

14. Verfahren nach irgendeinem der Ansprüche 1 bis 12, dadurch gekennzeichnet, dass die Teilchen mittels eines elektrischen Feldes beschleunigt werden, wodurch die für die örtliche Verflüssigung des Substrats erforderliche Energie ganz oder teilweise zugeführt werden kann.